# EUROPEAN PATENT SPECIFICATION

(11) **EP 1 710 324 B1**
(45) Date of publication and mention of the grant of the patent: **03.12.2008**
(21) Application number: 06112075.4
(22) Date of filing: 31.03.2006
(51) Int. Cl.: C23C 14/04, C23C 14/06

(54) **PVD process and chamber for the pulsed deposition of a chalcogenide material layer of a phase change memory device**
Gepulste PVD-Verfahren und -kammer für die Abscheidung von Chalkogenidschichten
Méthode et chambre de dépot PVD pulsé de chalcogénure pour des mémoires à changement de phase

(30) Priority: 08.04.2005 EP 05102812
(43) Date of publication of application: 11.10.2006
(73) Proprietor: STMicroelectronics S.r.l., 20041 Agrate Brianza (Milano) (IT)
(72) Inventor: MARANGON, Maria Santina, 23807, MERATE (IT); BESANA, Paola, 20010, BAREGGIO (IT); CECCHINI, Raimondo, 61020, CAGALLO DI MONTECALVO IN FOGLIA (IT); TRESOLDI, Mauro, 20061, CARUGATE (IT)
(74) Representative: Bartle, Robin Jonathan

(56) References cited:
- EP-A- 1 505 656
- GB-A- 1 061 949
- US-A- 6 031 287
- US-A- 6 113 750
- US-A1- 2004 040 835
- US-A1- 2004 114 413

## Description

The present invention relates to a process for physical vapour deposition of a chalcogenide material layer and a chamber for physical vapour deposition of a chalcogenide material layer of a phase change memory device.

As is known, phase change memory (PCM) elements exploit the characteristics of materials which have the property of changing between two phases having distinct electrical characteristics. For example, these materials may change from an amorphous phase, which is disorderly, to a crystalline or polycrystalline phase, which is orderly, and the two phases are associated to considerably different resistivities.

At present, alloys of group VI of the periodic table, such as Te or Se, referred to as chalcogenides or chalcogenic materials, can advantageously be used in phase change cells. The chalcogenide that currently offers the most promise is formed by a Ge, Sb and Te alloy (Ge₂Sb₂Te₅), also called GST, which is currently widely used for storing information in overwritable disks.

In chalcogenides, the resistivity varies by two or more magnitude orders when the material passes from the amorphous phase (more resistive) to the crystalline phase (more conductive) and vice versa.

Phase change can be obtained by locally increasing the temperature. Below 150°C, both phases are stable. Starting from an amorphous state, and raising the temperature above 200°C, there is a rapid nucleation of the crystallites and, if the material is kept at the crystallization temperature for a sufficiently long time, it undergoes a phase change and becomes crystalline. To bring the chalcogenide back to the amorphous state it is necessary to raise the temperature above the melting temperature (approximately 600°C) and then rapidly cool off the chalcogenide.

Memory devices exploiting the properties of phase change material (also called phase change memory devices) have been already proposed.

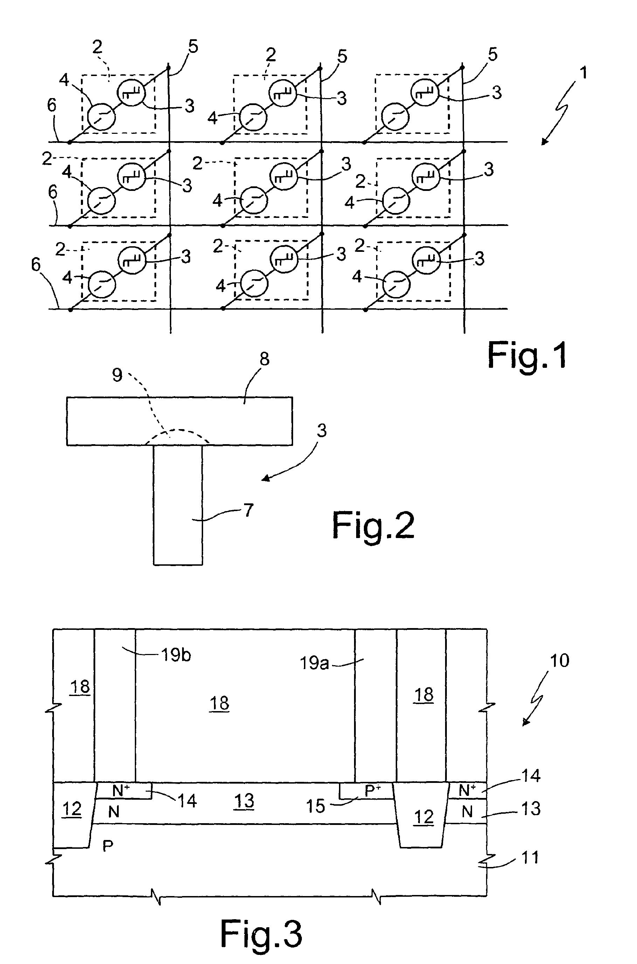

In a phase change memory including chalcogenic elements as a storage element, memory cells form an array and are arranged in rows and columns, as shown in Figure 1. The memory array 1 of Figure 1 comprises a plurality of memory cells 2, each formed by a memory element 3 of the phase change type and a selection element 4. The memory cells 2 are interposed at crosspoints of columns 5 (also called bit lines) and rows 6 (also called word lines).

The basic structure of a phase-change memory element 3 is shown in Figure 2 and comprises essentially a resistive element 7 (heater) and a programmable element 8. The programmable element 8 is made of a chalcogenide and is normally in the crystalline state. One part of the programmable element 8 is in direct contact with the resistive element 7 and forms a phase-change portion 9.

The composition of chalcogenides suitable for the use in a phase change memory device and a possible structure of a phase change element is disclosed in a number of documents (see, e.g., US-A-5,825,046).

The selection element 4 may be implemented by any switching device. In one embodiment, the selection element 4 is a PN diode, a bipolar junction transistor or a MOS transistor formed in the substrate of the chip integrating the memory device 1.

In another embodiment, the selection element 4 is an ovonic threshold switch that is made of a chalcogenide alloy that does not exhibit an amorphous to crystalline phase change and which undergoes rapid, electric field-initiated change in electrical conductivity that persists only so long as a holding voltage is present.

In both cases, selection element 4 operates as a switch that is either "off" or "on" depending on control quantities applied thereto.

Processes for manufacturing PCM cells and arrays have been already proposed; a detailed description of a known manufacturing process having a bipolar selection element may be found in EP-A-1 318 552. Another process for manufacturing a phase change memory array in Cudamascene technology is disclosed in European patent application N. 03425536.4 filed on 5 August 2003 in the name of the same applicant.

Considering for example the process disclosed in European patent application N. 03425536.4 (see also EP-A-1 318 552), starting from a wafer 10 having a substrate 11 of P-type, first insulation regions 12, base regions 13 of N-type, base contact regions 14 of N⁺-type, emitter regions 15 of P⁺-type are formed (Figure 3). A first dielectric layer 18 covers the substrate 11, base contacts 19b and emitter contacts 19a extend through the dielectric layer 18 and are in electrical contact with the base contact regions 14 and the emitter regions 15, respectively. The base regions 13 and emitter regions 15 form the selection element 4 of Figure 1.

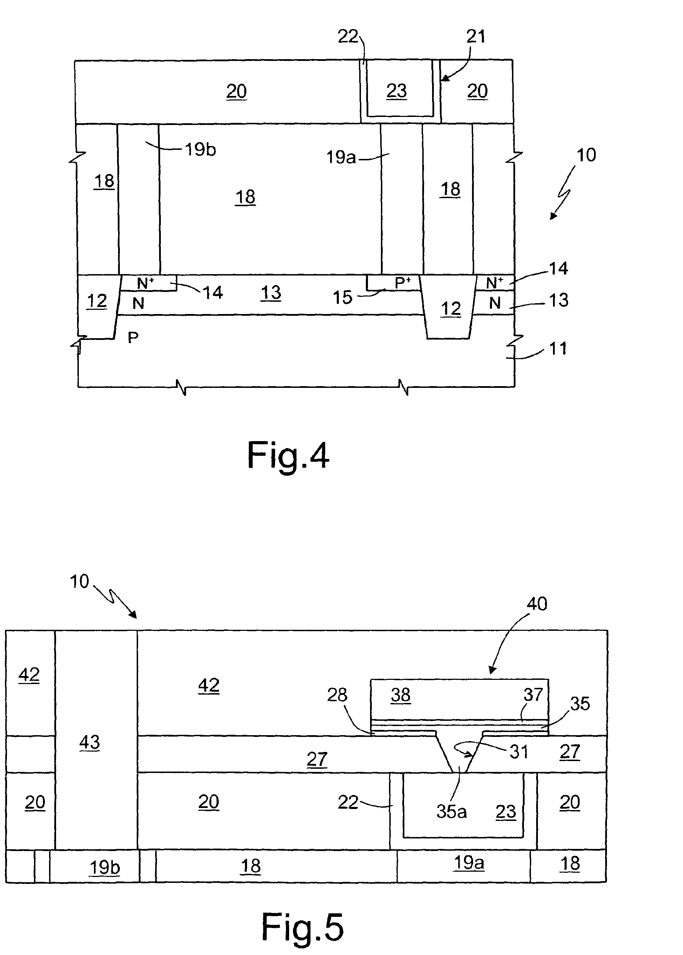

Next, Figure 4, a second dielectric layer 20 is deposited, and openings 21 are formed in the second dielectric layer 20 above the emitter contact 19a. The openings 21 have substantially rectangular or oval shape. A heating layer 22, for example of TiSiN, TiAlN or TiSiC, is deposited and conformally coats the walls and bottom of the openings 21. The openings 21 are then completely filled with dielectric material 23. The heating layer 22 and the dielectric material 23 are removed outside the openings 21 by CMP ("Chemical Mechanical Polishing") and the surface of the wafer 10 is planarized. The remaining portions of the heating layer 22 form a cup-shaped region 22.

Subsequently, a mold layer 27, preferably of silicon nitride having a thickness of 60-90 nm, and an adhesion layer 28, for instance Ti or Si with a thickness of 5 nm, are deposited. Later, layers 27 and 28 are etched so as to obtain a microtrench 31 which crosses the cup shaped region 22 at areas placed before and behind the plane of the drawing. Etching is carried out so that microtrench 31 has inclined walls. For example, etching may be a combined chemical and physical plasma, as disclosed in detail in above mentioned European patent application N. 03425536.4.

Then, a chalcogenic layer 35, for example of Ge₂Sb₂Te₅ (also called GST layer) with a thickness of 60 nm, is deposited conformally. A thin portion 35a of the chalcogenic layer 35 fills the microtrench 31 and forms, at the intersection with the cup-shaped region 22, the phase change region 7 of Figure 2. On top of the chalcogenic layer 35 a barrier layer 37, for example of Ti/TiN, and a metal layer 38, for example of AlCu, are deposited. The stack formed by the metal layer 38, barrier layer 37, chalcogenic layer 35, and adhesion layer 28 is defined using a same mask to form a bit line 40; a third dielectric layer 42 is deposited, planarized, for example by CMP, and then opened above the base contacts 19b and above a portion (not shown) of the bit line 40. The openings thus formed are filled with tungsten to form top contacts 43 in order to prolong upwards the base contacts 19b. Then standard steps are performed for forming the connection lines for connection to the base contacts 19b and to the bits lines 40, and the final structure of Figure 5 is thus obtained.

One critical step in the above process is the deposition of the GST or chalcogenic layer 35. In fact, a common deposition technique, like conventional sputtering, is difficult to be used for depositing layers of calcogenides, since the sputtering process could stop after a while or arcs could occur.

Another problem resides in the fact that for a proper functioning of the memory device, it is necessary that the GST layer be deposited conformally, in particular, that a sufficiently thick, uniform GST layer 35 is deposited on the bottom of the trench 31 in all conditions; furthermore it is important that no void areas are formed.

However, the above conditions are difficult to obtain in case of a GST layer 35 having a high thickness (e.g. greater than 120 nm) and/or when the microtrench 31 has a high aspect ratio (that is high depth compared with the width thereof).

In particular, tests carried out by the applicant have shown that while the conformality of GST layer 35 is quite good for thin films (of about 60 nm) and low-aspect ratio microtrenches 31, the increase in thickness of the GST film 35 being deposited causes an increase of the deposition thickness on the vertical walls of the microtrench, in particular on the upper edges thereof. As a result, for thick deposited layers and/or for high aspect ratio microtrenches 31 (in particular, in case of trenches having a higher depth than width), the formation of keyholes (that is void regions where no GST material is present) has been observed.

On the other hand, the use of thick GST films and/or high aspect ratio microtrenches 31 is required for modulating the current flowing through the memory device and/or to obtain small contact areas between the heater and the phase change regions of GST.

Test carried out by the applicant have however shown that changing deposition parameters (e.g. increasing the deposition temperature) does not allow to solve the above problem.

US 6,113,750 discloses a method of forming thin metal films using a PVD chamber having a collimator for imposing limitations on the direction of movement of sputtered particles and arranged between a target and a substrate holder.

US 2004/040835 discloses a pulse DC sputter deposition process for depositing a silver selenide film on a chalcogenic glass. The sputtering is performed at low pressure, with a power ranging between about 100 W and 500 W, preferably about 250 W, and a frequency ranging between 100 KHz and 250 KHz, preferably about 200 KHz.

EP-A-1 505 656 discloses a process for manufacturing a phase change memory array including a GST chalcogenic layer.

The object of the invention is thus to provide a method for depositing high conformal phase change layers also in case of thick layers and/or trenches or holes having a high aspect ratio.

According to the present invention, there are provided a method for depositing a chalcogenide material layer in a phase change memory and a deposition chamber, as defined respectively in claims 1 and 7, respectively.

The invention derives from the understanding that the interruption of the sputtering process or occurrence of arcing (e.g. a low impedance that appears at the output of the power supply) are due to the fact that, during sputtering, the chalcogenic material acts like an insulator. In fact, sputtering is caused when a negative voltage is applied to a target. Thus, the target attracts positive ions from the plasma which knocks loose a target ion and capture an electron from the target, becoming neutral. In the case of chalcogenic material, however, after a positive ion has caused the sputtering of the ion, the positive charge attracts an electron on the target surface or back plate and remains firmly connected thereto at the capture place. Thus, a sort of capacitor is formed, wherein one plate is the metal target, the insulator is the chalcogenic material to be sputtered, and the other plate is the surface of the calcogenic material. In the course of the sputtering process, ions arriving at the target surface continue charging the capacitor, reducing the voltage between the target and the plasma. In the end, sputtering could stop. Furthermore, the film, if uncapable to withstand the electric field created by charging, can brake down and initiate an arc. Arcs can generate particulate that can be ejected onto the substrate or can remain on the target and become a source for further arcing.

Furthermore, applicant has noted that the low conformality in the deposition of a GST layer is caused by the fact that the GST or chalcogenide ions sputtered by a target in a conventional deposition chamber and having a wide angular distribution are more likely to deposit in the upper part of the vertical or slightly sloped walls of the trench or hole than in the lower part of the walls and thus cause the deposited film to grow preferentially in those areas. As deposition proceeds, the more rapidly increasing portions of the deposited film at the upper corners reduce progressively the chances that the sputtered ions reach the bottom portion of the walls, preventing in the end the passage of the sputtered ions to the bottom of the hole and thus the filling thereof; thereby the finished device may present keyholes.

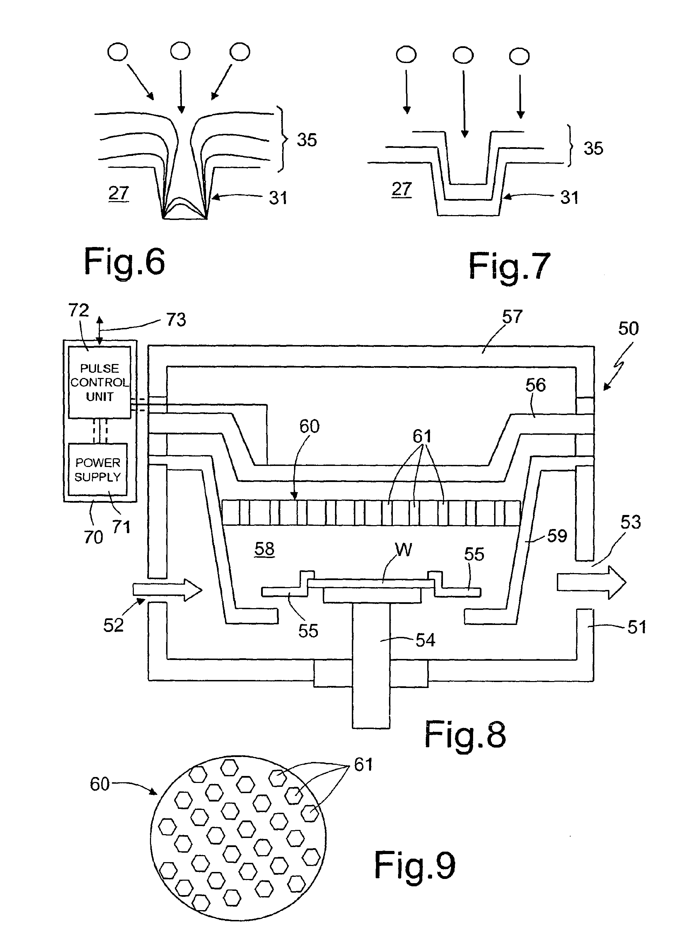

This situation is depicted in figure 6, showing a schematic, exaggerated representation of the deposition of GST layer 35 in microtrench 31 for different thicknesses of the GST layer 35.

Thus, by altering the angular distribution of the sputtered ions and, more specifically, causing only collimated ions having a desired direction to reach the deposition area, it is possible to obtain a smoother and more uniform grow in all the portions of the hole, solving the above problem.

For the understanding of the present invention, a preferred embodiment is now described, purely as a non-limitative example, with reference to the enclosed drawings, wherein:
- Figure 1 is a schematic diagram illustrating the scheme of a phase change memory;
- Figure 2 shows the basic structure of a known chalcogenic element;
- Figures 3-5 are cross-sections through a semiconductor wafer in successive manufacturing steps of a phase change memory device;
- Figure 6 is a schematic illustration of the irregular growth of an GST film according to a conventional method;
- Figure 7 is a schematic illustration of the regular growth of an GST film according to the invention;
- Figure 8 shows a cross-section of a deposition chamber according to an embodiment of the invention;
- Figure 9 shows a top view of a collimator mounted in the deposition chamber of Figure 8; and
- Figure 10 is a system depiction of one embodiment of the present invention.

According to one aspect of the invention, the deposition chamber is modified so as to transform the flux of ions sputtered by the target and having a wide angular distribution, into a "collimated" beam or flux that is allowed to hit the wafer surface. Here "collimated" beam or flux refers to a group of ions having mainly a desired direction. The "collimation" of the hitting ions is here obtained by preventing ions directed along undesired direction to reach the wafer surface through a screen or "collimator". A collimator causes ions arriving at the collimator with a sloped direction to be more likely intercepted by the collimator.

Furthermore, a pulsed type sputtering technique is used, so as to avoid the above described problems of charging and arcing. In particular, during sputtering, the voltage applied to the target is periodically reversed, e.g. to a tenth or a twentieth of the operating target voltage. The voltage reversal attracts electrons to the target, discharging any ions remaining on the surface thereof, but does not affect the plasma, by virtue of its low value. When the voltage is reversed back to the negative value, sputtering of the chalcogenide is resumed.

Figure 7 shows schematically the uniform deposition observed for different thickness GST films 35 using collimated ions, to be compared with the situation of the conventional method of Figure 6.

A deposition chamber according to an embodiment of the invention is represented in Figure 8, showing only the components essential to the comprehension of the invention.

Chamber 50 has an external wall 51 with a gas inlet 52 and a gas outlet 53. Gas outlet 53 is connected to a pump, not shown. The wall 51 is upwardly closed by an upper cover 57. A holder 54 supports a wafer W, held by means of clamps 55. A target 56 extends in the chamber 50 and a shield 59 delimits, with holder 54 and the target 56, a space 58 within the chamber 50.

The target 56 is connected to a DC pulsing plasma power supply 70 including a power supply unit 71 and a pulse control unit 72. The power supply unit 71 generates a high voltage which is periodically reversed by the pulse control unit 72. The output of the pulse control unit 72 is connected directly to the target 56. The pulse control unit 72 has also an input/output 73 for connection to user controls. An example of a DC pulsing plasma power supply 70 is e.g. described in US 5,427,669, and causes a pulsed sputtering of ions and thus sputtering of chalcogenides. For example, the voltage applied to the target 56 may be reversed with a frequency of 20 to 100 kHz, the applied direct voltage is comprised in the range 200 to 600 Volts and the reversed voltage is comprised in the range 20 to 120 Volts.

A collimator 60 extends in the space 58. As better shown in Figure 9, the collimator 60 is a holed disk having a number of holes 61 for preferentially allowing ions having a direction perpendicular to the collimator 60 to pass through and hit the wafer W. The geometrical parameters of the collimator 60, such as the aspect ratio of the holes 61 and the distance of collimator 60 from the target 56, influence the number of the ions passing through the collimator and having a direction different from the perpendicular one (angular distribution width) as discussed for the deposition of Ti in "Theoretical and practical aspects of collimated sputtering" S. K. Dew, J. Appl. Phys. 76(8), 15 October 1994.

The use of a pulsed type sputtering, together with the use of a collimator 60 in the chamber 50, allows a high conformality deposition of the GST layer 35 in the trench 31 to be achieved.

Tests performed by the applicant have confirmed that the use of a pulsed sputtering and of the collimator 60 allows the obtainment of a GST layer 35 having a very good bottom coverage (ratio between the GST thickness at the bottom of the trench 31 and on flat surface).

In particular, from test samples prepared by the applicant, a bottom coverage of 67% has been observed in standard non-collimated samples, and a 93% bottom coverage has been observed in analog novel collimated samples.

In other test samples, wherein a metal layer was deposited on top of the GST/cap layer, voids have been observed in a standard process sample, while the deposition is conformal, in collimated samples.

As demonstrated by the test samples, the use of the present process allows obtainment of a high conformality of the GST layer in PCM cells, improves the bottom coverage and morphology of the GST layer and of the overlying cap layers. In particular, an improvement of about 15% has been observed in the GST bottom coverage with respect to different techniques. The process is also more reproducible.

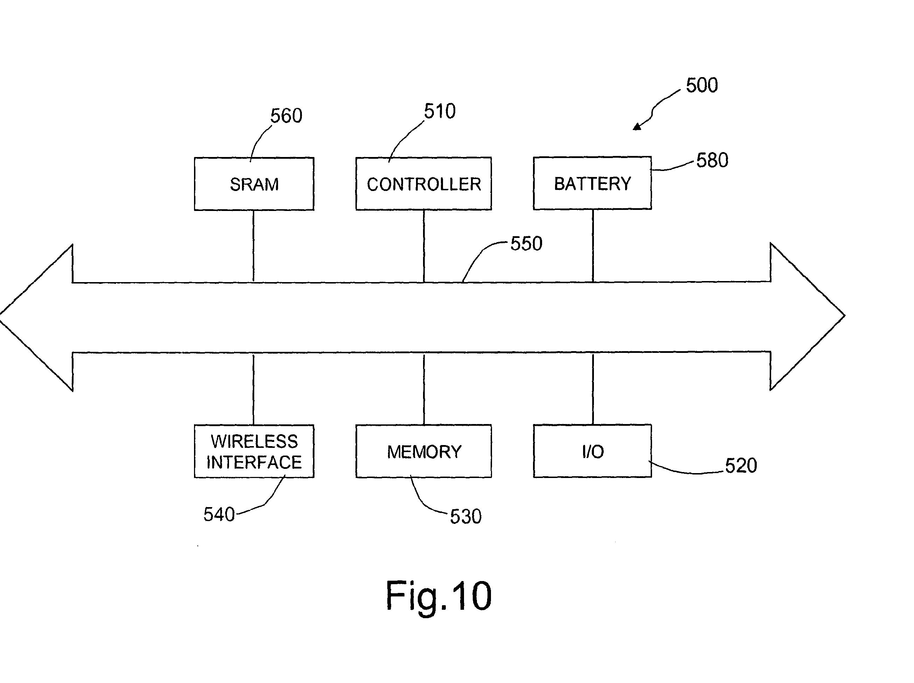

Turning to Figure 10, a portion of a system 500 in accordance with an embodiment of the present invention is described. System 500 may be used in wireless devices such as, for example, a personal digital assistant (PDA), a laptop or portable computer with wireless capability, a web tablet, a wireless telephone, a pager, an instant messaging device, a telephone, a pager, an instant messaging device, a digital music player, a digital camera, or other devices that may be adapted to transmit and/or receive information wirelessly. System 500 may be used in any of the following systems: a wireless local area network (WLAN) system, a wireless personal area network (WPAN) system, or a cellular network, although the scope of the present invention is not limited in this respect.

System 500 includes a controller 510, an input/output (I/O) device 520 (e.g. a keypad, display), a memory 530, a wireless interface 540, and a static random access memory (SRAM) 560, coupled to each other via a bus 550. A battery 580 may supply power to the system 500.

Controller 510 comprises, for example, one or more microprocessors, digital signal processors, microcontrollers, or the like. Memory 530 may be used to store messages transmitted to or by system 500. Memory 530 may also optionally be used to store instructions that are executed by controller 510 during the operation of system 500, and may be used to store user data. Memory 530 comprises a memory array as shown in Fig. 1.

The I/O device 520 is used to generate a message. The system 500 uses the wireless interface 540 to transmit and receive messages to and from a wireless communication network with a radio frequency (RF) signal. Examples of the wireless interface 540 include an antenna, or a wireless transceiver.

Finally, it is clear that numerous variations and modifications may be made to the method and chamber described and illustrated herein, all falling within the scope of the invention as defined in the attached claims. In particular, it is stressed that the present invention is not limited to GST, but applies to any chalcogenic material. Analogously, the invention is not limited to the specific type of phase change memory elements as disclosed.

## Claims

1. A method for depositing a chalcogenide layer (35) of GST in a phase change memory (1), the method comprising depositing the GST chalcogenide layer (35) by physical vapour deposition in a deposition chamber (50),
**characterized by**:
introducing a collimator (60) in said deposition chamber (50) before depositing; and
pulsedly sputtering the GST chalcogenide layer (35).

2. A method according to claim 1, wherein introducing a collimator (60) includes placing a collimator having a plurality of holes (61) between a sputter target (56) and a wafer (W).

3. A method according to claim 1 or 2, comprising, before depositing, forming a mold layer (27) having an aperture (31) on a surface of a wafer (10), wherein depositing comprises conformally depositing said chalcogenide layer (35) on said surface and in said aperture (31).

4. A method according to claim 3, for manufacturing a phase change memory cell (2), including, before forming a mold layer (27), forming a resistive heater element (22) in a dielectric layer (20), said resistive heater element extending below said aperture (31) thereby said resistive heater element (22) is in electrical contact with a portion (35a) of said chalcogenide layer (35) in said aperture (31), said portion (35a) defining a phase change region; the process further comprising defining said chalcogenide layer (35); forming a select element (13-15) in electrical contact with said phase change portion (35a); and forming connection lines (38) in electrical contact with said phase change region (35a) and said select element (13-15).

5. The method according to any of claims 1-4, wherein the step of depositing a chalcogenide layer (35) comprises applying a DC sputtering voltage to a sputter target and periodically reversing said DC sputtering voltage.

6. The method according to claim 5, wherein said DC sputtering voltage is comprised between 200 and 600 volts and is reversed with a frequency comprises between 20 and 100 KHz.

7. A physical vapour deposition chamber (50) used for depositing a GST chalcogenide layer (35) according to the method of any claims 1-6, the chamber (50) comprising:
a wall (51) surrounding a space (58) and closed by a cover (57);
a holder (54) for a wafer (W) extending in said space;
a target (56) in said space (58) between said cover (57) and said holder (54); and
a collimator (60) in said space (58) between said target (56) and said holder (54),
**characterized by** a pulsing plasma power supply (70) connected to said target (56) so as to pulsedly sputter the GST chalcogenide layer (35) on said wafer.

8. Chamber according to claim 7, comprising a DC power supply unit (71) generating a DC sputtering voltage and a pulse control unit (72) configured to periodically reverse the DC sputtering voltage.

9. Chamber according to claim 8, wherein said DC power supply unit (71) is configured to generate the DC sputtering voltage comprised between 200 and 600 volts and the pulse control unit (72) is configured to reverse the DC sputtering voltage with a frequency comprised between 20 and 100 KHz to obtain a reversed pulsed voltage comprised between 20 a 120 volts.

## Patentansprüche

1. Verfahren zum Auftragen einer Chalcogenidschicht (35) aus GST in einem Phasenänderungsspeicher (1), wobei das Verfahren das Auftragen der GST-Chalcogenidschicht (35) durch physikalische Dampfabscheidung (PVD) in einer Auftragskammer (50) beinhaltet, **gekennzeichnet durch**:
Einführen eines Kollimators (60) in die genannte Auftragskammer (50) vor dem Auftragen; und
pulsiertes Zerstäuben der GST-Chalcogenidschicht (35).

2. Verfahren nach Anspruch 1, wobei das Einführen eines Kollimators (60) das Platzieren eines Kollimators mit mehreren Löchern (61) zwischen einem Sputter-Target (56) und einem Wafer (W) beinhaltet.

3. Verfahren nach Anspruch 1 oder 2, das vor dem Auftragen das Ausbilden einer Formschicht (27) mit einer Öffnung (31) auf einer Oberfläche eines Wafers (10) beinhaltet, wobei das Auftragen das konforme Auftragen der genannten Chalcogenidschicht (35) auf die genannte Oberfläche und in die genannte Öffnung (31) beinhaltet.

4. Verfahren nach Anspruch 3 zur Herstellung einer Phasenänderungsspeicherzelle (2), das das Ausbilden, vor dem Bilden einer Formschicht (27), eines Widerstandsheizelementes (22) in einer dielektrischen Schicht (20) beinhaltet, wobei das genannte Widerstandsheizelement unterhalb der genannten Öffnung (31) verläuft, so dass das genannte Widerstandsheizelement (22) mit einem Abschnitt (35a) der genannten Chalcogenidschicht (35) in der genannten Öffnung (31) in elektrischem Kontakt ist, wobei der genannte Abschnitt (35a) eine Phasenänderungsregion definiert; wobei das Verfahren ferner Folgendes beinhaltet: Definieren der genannten Chalcogenidschicht (35); Bilden eines Auswahlelementes (13-15) in elektrischem Kontakt mit dem genannten Phasenänderungsabschnitt (35a); und Ausbilden von Verbindungsleitungen (38) in elektrischem Kontakt mit der genannten Phasenänderungsregion (35a) und dem genannten Auswahlelement (13-15).

5. Verfahren nach einem der Ansprüche 1-4, wobei der Schritt des Auftragens einer Chalcogenidschicht (35) das Anlegen einer Zerstäubungsgleichspannung an ein Sputter-Target und das periodische Umkehren der genannten Zerstäubungsgleichspannung beinhaltet.

6. Verfahren nach Anspruch 5, wobei die genannte Zerstäubungsgleichspannung zwischen 200 und 600 Volt liegt und mit einer Frequenz zwischen 20 und 100 KHz umgekehrt wird.

7. Physikalische Dampfabscheidungs-(PVD)-kammer (20) zum Auftragen einer GST-Chalcogenidschicht (35) mit dem Verfahren nach einem der Ansprüche 1-6, wobei die Kammer (50) Folgendes umfasst:
eine Wand (51) um einen Raum (58), der mit einem Deckel (57) verschlossen ist;
einen Halter (54) für einen Wafer (W), der sich in den genannten Raum erstreckt;
ein Target (56) in dem genannten Raum (58) zwischen dem genannten Deckel (57) und dem genannten Halter (54); und
einen Kollimator (60) in dem genannten Raum (58) zwischen dem genannten Target (56) und dem genannten Halter (54),
**gekennzeichnet durch** eine pulsierte Plasma-Energieversorgung (70), die mit dem genannten Target (56) verbunden ist, um die GST-Chalcogenidschicht (35) pulsierend auf den genannten Wafer aufzustäuben.

8. Kammer nach Anspruch 7, die eine Gleichstromversorgungseinheit (71) zum Erzeugen einer Zerstäubungsgleichspannung und eine Impulssteuereinheit (72) umfasst, die zum periodischen Umkehren der Zerstäubungsgleichspannung konfiguriert ist.

9. Kammer nach Anspruch 8, wobei die genannte Gleichstromversorgungseinheit (71) so konfiguriert ist, dass sie die Zerstäubungsgleichspannung zwischen 200 und 600 Volt erzeugt, und die Impulssteuereinheit (72) so konfiguriert ist, dass sie die Zerstäubungsgleichspannung mit einer Frequenz zwischen 20 und 100 KHz umkehrt, um eine umgekehrte pulsierte Spannung zwischen 20 und 120 Volt zu erzielen.

## Revendications

1. Un procédé destiné à déposer une couche de chalcogénure (35) de GST dans une mémoire à changement de phase (1), le procédé comprenant le dépôt de la couche de chalcogénure GST (35) par dépôt physique en phase vapeur dans une chambre de dépôt (50),
**caractérisée par** :
l'introduction d'un collimateur (60) dans ladite chambre de dépôt (50) avant l'opération de dépôt, et
la pulvérisation de manière pulsée de la couche de chalcogénure GST (35).

2. Un procédé selon la Revendication 1, où l'introduction d'un collimateur (60) comprend l'installation d'un collimateur possédant une pluralité de trous (61) entre une cible de pulvérisation (56) et une plaquette (W).

3. Un procédé selon la Revendication 1 ou 2, comprenant, avant l'opération de dépôt, la formation d'une couche de moulage (27) possédant une ouverture (31) sur une surface d'une plaquette (10), où l'opération de dépôt comprend le dépôt de manière conforme de ladite couche de chalcogénure (35) sur ladite surface et dans ladite ouverture (31).

4. Un procédé selon la Revendication 3 de fabrication d'une cellule de mémoire à changement de phase (2), comprenant, avant la formation d'une couche de moulage (27), la formation d'un élément résistance chauffante (22) dans une couche diélectrique (20), ledit élément résistance chauffante s'étendant en dessous de ladite ouverture (31), ledit élément résistance chauffante (22) étant ainsi placé en contact électrique avec une partie (35a) de ladite couche de chalcogénure (35) dans ladite ouverture (31), ladite partie (35a) définissant une zone de changement de phase, le processus comprenant en outre la définition de ladite couche de chalcogénure (35), la formation d'un élément sélecteur (13-15) en contact électrique avec ladite partie de changement de phase (35a), et la formation de lignes de connexion (38) en contact électrique avec ladite zone de changement de phase (35a) et ledit élément sélecteur (13-15).

5. Le procédé selon l'une quelconque des Revendications 1 à 4, où l'opération de dépôt d'une couche de chalcogénure (35) comprend l'application d'une tension de pulvérisation en c.c. à une cible de pulvérisation et périodiquement l'inversion de ladite tension de pulvérisation en c.c.

6. Le procédé selon la Revendication 5, où ladite tension de pulvérisation en c.c. est comprise entre 200 et 600 volts et est inversée avec une fréquence comprise entre 20 et 100 KHz.

7. Une chambre de dépôt physique en phase vapeur (50) utilisée pour déposer une couche de chalcogénure GST (35) selon le procédé de l'une quelconque des Revendications 1 à 6, la chambre (50) comprenant :
une paroi (51) entourant un espace (58) et fermée par un couvercle (57) et
un support (54) pour une plaquette (W) s'étendant dans ledit espace,
une cible (56) dans ledit espace (58) entre ledit couvercle (57) et ledit support (54), et
un collimateur (60) dans ledit espace (58) entre ladite cible (56) et ledit support (54),
**caractérisé par** un bloc d'alimentation électrique à plasma pulsé (70) connecté à ladite cible (56) de façon à pulvériser de manière pulsée la couche de chalcogénure GST (35) sur ladite plaquette.

8. Une chambre selon la Revendication 7, comprenant un bloc d'alimentation électrique en c.c. (71) générant une tension de pulvérisation en c.c. et une unité de commande à impulsion (72) configurée de façon à inverser périodiquement la tension de pulvérisation en c.c.

9. Une chambre selon la Revendication 8, où ledit bloc d'alimentation électrique en c.c. (71) est configuré de façon à générer la tension de pulvérisation en c.c. comprise entre 200 et 600 volts et l'unité de commande à impulsion (72) est configurée de façon à inverser la tension de pulvérisation en c.c. avec une fréquence comprise entre 20 et 100 KHz de façon à obtenir une tension pulsée inversée comprise entre 20 et 120 volts.
